# EUROPEAN PATENT APPLICATION

(11) **EP 2 426 705 A1**
(43) Date of publication of application: **07.03.2012**
(21) Application number: 10769527.2
(22) Date of filing: 30.04.2010
(51) Int. Cl.: H01L 21/304

(54) **METHOD FOR CLEANING OF SEMICONDUCTOR SUBSTRATE AND ACIDIC SOLUTION**

(30) Priority: 30.04.2009 JP 2009111488
(71) Applicant: Lion Corporation, Tokyo 130-8644 (JP)
(72) Inventor: HIDAKA, Makoto, Tokyo 130-8644 (JP); OGURA, Taku, Tokyo 130-8644 (JP); KIKUCHI, Maiko, Tokyo 130-8644 (JP); KAGEYAMA, Motohiro, Tokyo 130-8644 (JP); TAKASHIMA, Masayuki, Tokyo 130-8644 (JP)
(74) Representative: Vuillermoz, Bruno
(86) International application number: PCT/JP2010/003090
(87) International publication number: WO 2010/125827

(57) **Abstract**

Disclosed is a cleaning method which can remove, particularly, all of an organic contaminant, a particle contaminant, and a metal contaminant adhered to a semiconductor substrate at a high cleaning level, and which can realize the reduction in environmental load caused by the cleaning. The method of cleaning the semiconductor substrate includes a first cleaning process of cleaning the semiconductor substrate with a cleaning composition including a transition-metal-containing water-soluble salt (A), a chelating agent (B1), and a peroxide (C), a ratio of the chelating agent (B1) to the transition-metal-containing water-soluble salt (A) being 0.5 molar equivalent or more; and a second cleaning process of cleaning the semiconductor substrate, which is cleaned through the first cleaning process, with an acidic solution containing a chelating agent (B2).

## Description

### Technical Field

The present invention relates to a method of cleaning a semiconductor substrate, and an acidic solution used in the cleaning method.
Priority is claimed on Japanese Patent Application No. 2009-111488, filed April 30,2009.

### Background Art

In an electronic device, a minute contaminant may cause a malfunction or a decrease in a performance, such that it is necessary to substantially completely remove an ultra-minute contaminant on an electronic device substrate such as a display substrate used for a semiconductor substrate, a hard disk substrate, a liquid crystal panel or the like. Therefore, in precision cleaning in an industrial field, it is necessary to remove contaminants adhered to an electronic device substrate at an extremely high cleaning level.
As the above-described contaminant, an organic contaminant derived from a substrate fixing agent such as wax, or the human body, or the like; a particle contaminant caused by an abrasive agent such as colloidal silica, a floating particle in the air, or the like; a metallic contaminant caused by a metal such as Fe, Na, and Cu, and a metallic ion; or a mixture thereof may be exemplified.

To obtain the cleaning level that is required depending on the electronic device substrate that is set as an object to be cleaned or the type of contaminant adhered to the electronic device substrate, various precision cleaning technologies have been suggested in the related art.

For example, in precision cleaning in which a semiconductor substrate is set as an object to be cleaned, a method of performing the cleaning process with a hydrogen peroxide and a strong acid (sulfuric acid, hydrochloric acid, or the like), a hydrogen peroxide and an alkali (ammonia or the like), and a hydrofluoric acid, that is, a cleaning method called "RCA cleaning" has been widely used (for example, refer to NPL 1 and PTL 1).
In addition, particularly, in a semiconductor device using silicon carbide, or the like, a cleaning method of removing a metallic contaminant on a surface of silicon carbide has been suggested (refer to PTL 2).

### Citation List

### Patent Literature

[PTL 1] Japanese Patent Application Laid-Open No. 2003-86792
[PTL 2] Japanese Patent Application Laid-Open No. 2005-47753

### Non-Patent Literature

[NPL 1] RCA Review, p. 187, June 1970

### Summary of Invention

### Technical Problem

However, generally, in the "RCA cleaning", there has been adopted a process (a multi-bath immersion process), in which after performing cleaning processes (plural cleaning steps) with a hydrogen peroxide and a strong acid, a hydrogen peroxide and an alkali, and a hydrofluoric acid, respectively, a rinsing process is performed plural times using a large amount of ultrapure water, such that the environmental load becomes large in this cleaning method.
In addition, in the "RCA cleaning", the strong acid or alkali is used at a high concentration and a high temperature, and the hydrofluoric acid that is a highly toxic aqueous solution is used, such that workability is poor, and equipment for realizing corrosion resistance or ventilation is necessary.
In addition, when the "RCA cleaning" that is developed for cleaning a silicon semiconductor substrate is applied for cleaning a semiconductor silicon carbide substrate that uses silicon carbide that has a physical property different from that of silicon, it is difficult to obtain a sufficient cleaning effect with respect to an organic contamination or a particle contamination. Furthermore, in the "RCA cleaning", it is necessary to use hydrofluoric acid that is a highly toxic aqueous solution to perform the cleaning through a removal of the metallic contamination or an etching.

Particularly, in the invention disclosed in PTL 2, it is difficult to sufficiently remove the organic contamination and particle contamination adhered to the semiconductor substrate, and therefore it is difficult to obtain a cleaning level necessary for the semiconductor substrate with respect to the organic contamination and particle contamination.

The present invention has been made in consideration of the above-described circumstances, it is an object of the invention to provide a cleaning method which can remove, particularly, an organic contaminant, a particle contaminant, or a metal contaminant adhered to a semiconductor substrate at a high cleaning level, and which enables the reduction in the environmental load caused by the cleaning.

### Solution to Problem

The present inventors have carried out extensive research, and provide the following means to solve the above-described problems.
Specifically, according to an embodiment of the invention, there is provided a method of cleaning a semiconductor substrate of the invention. The method includes a first cleaning process of cleaning the semiconductor substrate with a cleaning composition including a transition-metal-containing water-soluble salt (A), a chelating agent (B1), and a peroxide (C), a ratio of the chelating agent (B1) to the transition-metal-containing water-soluble salt (A) being 0.5 molar equivalents or more; and a second cleaning process of cleaning the semiconductor substrate, which is cleaned through the first cleaning process, with an acidic solution containing a chelating agent (B2).

In the method of cleaning a semiconductor substrate according to the invention, it is preferable that the chelating agent (B1) be a polycarboxylic acid-based compound.

In addition, in the method of cleaning a semiconductor substrate according to the invention, it is preferable that the chelating agent (B2) be a polycarboxylic acid-based compound.

In addition, in the method of cleaning a semiconductor substrate according to the invention, it is preferable that an amount of iron contained as an impurity in the chelating agents (B1) and (B2) be 0.2 ppm or less. (In addition, the lower limit of the iron is 0.0 ppm).

In addition, in the method of cleaning a semiconductor substrate according to the invention, it is preferable that the semiconductor substrate be a silicon carbide semiconductor substrate.

According to another embodiment of the invention, there is provided an acidic solution which is used in a method of cleaning semiconductor substrate according to the invention, and which includes a chelating agent (B2).

### Advantageous Effects of Invention

According to the method of cleaning a semiconductor substrate of the inventon, it is possible to remove, particularly, an organic contaminant, a particle contaminant, or a metal contaminant adhered to a semiconductor substrate at a high cleaning level, and to realize a reduction of the environmental load caused by the cleaning. Particularly, in a case where the amount of iron included in the chelating agents (B1) and (B2) is reduced, it is possible to realize the removal of the iron at an even higher cleaning level.
In addition, when the acidic solution of the invention is used, it is possible to remove the metallic contamination at a high cleaning level that is required for, particularly, a semiconductor substrate.

### Description of Embodiments

### Method of Cleaning Semiconductor Substrate

A method of cleaning semiconductor substrate of the invention includes a first cleaning process of cleaning the semiconductor substrate with a specific cleaning composition, and a second cleaning process of cleaning the semiconductor substrate, which is cleaned through the first cleaning process, with a specific acidic solution.

### First Cleaning Process

In a first cleaning process, a semiconductor substrate is cleaned with a cleaning composition including a transition-metal-containing water-soluble salt (A), a chelating agent (B1), and a peroxide (C), a ratio of the chelating agent (B1) to the transition-metal-containing water-soluble salt (A) being 0.5 molar equivalents or more.
The cleaning method is not particularly limited, and a method of immersing the semiconductor substrate in a cleaning composition may be exemplified as an example.
Specifically, first, a semiconductor substrate to be cleaned is put in a cleaning bath. At this time, it is preferable that the semiconductor substrate be fixed so as not to come into contact with the inner bottom surface and an inner surface of the cleaning bath. In this manner, it is possible to prevent a contaminant from remaining on the contact portion between the inner bottom surface and the inner surface and the semiconductor substrate.
Subsequently, the cleaning composition is poured into the cleaning bath and then the semiconductor substrate is immersed in the cleaning composition.
Then, after the immersion of the semiconductor substrate for a predetermined time, the semiconductor substrate is taken out from the cleaning composition in the cleaning bath.

The immersion processing time of the semiconductor substrate in the cleaning composition is not particularly limited, but it is preferable to perform this immersion process for 1 to 90 minutes, and more preferably 10 to 30 minutes.
In addition, a temperature in the cleaning bath is not particularly limited, but it is preferable that the temperature be 5 to 95°C, and more preferably 15 to 80°C. When the temperature is within the above-described range, blended components of the cleaning composition are well dissolved, and therefore it is possible to reliably obtain the cleaning effect with respect to the organic contaminant and the particle contaminant.

The cleaning method in the first cleaning process may be a method other than the method of immersing the semiconductor substrate in the cleaning composition, and for example, a method of directly spraying the cleaning composition from a nozzle or the like and applying it to the semiconductor substrate, and performing the cleaning, or the like may be exemplified.

### Second Cleaning Process

In a second cleaning process, the semiconductor substrate, which is cleaned through the first cleaning process, is cleaned with an acidic solution containing a chelating agent (B2).
The cleaning method is not particularly limited, but as an example, a method of immersing the semiconductor substrate, which is cleaned through the first cleaning process, in the acidic solution may be exemplified.
Specifically, in the first cleaning process, the semiconductor substrate taken out from the cleaning composition in the cleaning bath is rinsed with flowing pure water (preferably, ultrapure water) and as a result, the cleaning composition and contaminants remaining on the semiconductor substrate are removed.
The method of removing the cleaning composition and the contaminants remaining on the semiconductor substrate is not particularly limited, but for example, an overflow rinsing which is performed by making pure water (preferably, ultrapure water) to overflow in a pure water (preferably, ultrapure water) bath, a batch type tank rinsing, and a quick dump rinsing may be exemplified (hereinafter, these rinsing processes are referred to as a "rinsing process").
Then, the semiconductor substrate is moved into an acid cleaning bath, an acidic solution is poured into the acid cleaning bath, and the semiconductor substrate is immersed in the acidic solution.
After the immersion for a predetermined time, the semiconductor substrate is taken out from the acidic solution in the acid cleaning bath.

An immersion processing time of the semiconductor substrate in the acidic solution is not particularly limited, but it is preferable to perform this immersion process for 1 to 90 minutes, and more preferably 5 to 30 minutes.
In addition, the temperature in the acid cleaning bath is not particularly limited, but it is preferable that the temperature be 5 to 95°C, and more preferably 15 to 80°C. When the temperature is within the above-described range, blended components of the acidic solution are well dissolved, and therefore it is possible to reliably obtain the cleaning effect with respect to the metallic contaminant.

Subsequently, the semiconductor substrate is subjected to a rinsing process again, and thereby the acidic solution and contaminants remaining on the semiconductor substrate are removed.
Then, the semiconductor substrate after the rinsing process is subjected to a drying process through a drying method such as spin drying, vacuum drying, warm-air drying, warm isopropyl alcohol (IPA) lifting drying, IPA substitution drying, and IPA vapor drying, and thereby the pure water remaining on the semiconductor substrate is removed.

It is preferable that the cleaning of the semiconductor substrate using the acidic solution in the second cleaning process be repeatedly performed plural times. When the cleaning is repeatedly performed using the acidic solution, it is possible to obtain a relatively high cleaning level with respect to the metallic contaminant. In this way, in the present invention, even when the cleaning using the acidic solution is repeated, it is possible to perform precision cleaning without causing any damage to the semiconductor sub strate.

The cleaning method in the second cleaning process may be a method other than the method of immersing the semiconductor substrate in the acidic solution, and for example, a method of cleaning the semiconductor substrate with a flowing acidic solution, or the like may be exemplified.

A cleaning apparatus, a rinsing apparatus, and a drying apparatus that are used in the above-described first and second cleaning processes are not particularly limited.

In addition, in regard to the first cleaning process or the second cleaning process, an ultrasonic process may be performed during the cleaning process or the rinsing process. When the ultrasonic process is performed during the cleaning process or the rinsing process, it is possible to obtain a high cleaning level with respect to the organic contaminant, the particle contaminant, and the metallic contaminant adhered to the semiconductor substrate. Particularly, a cleaning level with respect to the particle contaminant is increased.

Conditions of the ultrasonic process during the cleaning are not particularly limited as long as an ultrasonic strength and a processing time, which are sufficient to disperse the contaminants adhered to the semiconductor substrate in the cleaning composition or the acidic solution, are secured.
For example, it is preferable that an oscillation frequency in an ultrasonic vibrator be 200 kHz to 2 MHz, and more preferably 500 kHz to 1 MHz. When the oscillation frequency is equal to or greater than 200 kHz, a mechanical force derived from ultrasonic waves does not become too strong, and therefore it is possible to perform the cleaning without causing damage to the semiconductor substrate. When the oscillation frequency is equal to or less than 2 MHz, the effect of removing the contaminant on the semiconductor substrate is improved.
An ultrasonic processing time is not particularly limited, but it is preferable that the ultrasonic waves always be emitted during the cleaning process in the first cleaning process or the second cleaning process.
In addition, a temperature in the cleaning bath or the acid cleaning bath during the ultrasonic process is not particularly limited, but it is preferable the temperature be 5 to 95°C, and more preferably 15 to 80°C. When the temperature is within the above-described range, blended components of the cleaning composition or the acidic solution are well dissolved, and therefore it is possible to reliably obtain the cleaning effect with respect to the organic contaminant, the particle contaminant, and the metallic contaminant.

Conditions (an oscillation frequency in the ultrasonic vibrator and a cleaning time) of the ultrasonic process during the rinsing process are not particularly limited, and are the same as those in the ultrasonic process in the above-described cleaning.
In addition, a temperature of the pure water (preferably, ultrapure water) during the rinsing process is not particularly limited.

The method of cleaning the semiconductor substrate of the invention may include another process between the first cleaning process and the second cleaning process.

### Semiconductor Substrate

As a semiconductor substrate, for example, a silicon semiconductor substrate, a silicon carbide semiconductor substrate, a sapphire semiconductor substrate, a diamond semiconductor substrate, a gallium nitride semiconductor substrate, a gallium arsenide semiconductor substrate, or the like may be exemplified.
Among these, when the cleaning method of the invention is used, it is possible to remove all of the organic contaminant, the particle contaminant, and the metallic contaminant at a high cleaning level without deteriorating semiconductor characteristics, such that the silicon carbide semiconductor substrate is preferable.

### Cleaning composition

The cleaning composition in the present invention includes a transition-metal-containing water-soluble salt (A) (hereinafter, referred to as "(A) component"), a chelating agent (B1) (hereinafter, referred to as "(B1) component"), and a peroxide (C) (hereinafter, referred to as "(C) component", and a ratio of the (B1) component to the (A) component is 0.5 molar equivalents or more.
A method of preparing the cleaning composition is not particularly limited, and may be prepared by sequentially blending each component with compliance to a normal method. An apparatus used for the preparing of the cleaning composition is not particularly limited.
When the cleaning composition is prepared, the (A) component and the (B1) component may be used as a mixture obtained by mixing and drying both components in advance, or may be separately blended. In addition, the (A) component and the (B 1) component may be blended as a metallic complex (a complex compound, a complex salt) formed by mixing the (A) component and the (B1) component.
In addition, it is preferable that a blending sequence of the (A) component and the (C) component be apart from each other. In this manner, it is possible to suppress hydrogen peroxide generated from the (C) component from being decomposed, and therefore it is possible to reliably prepare the cleaning composition.
In addition, it is also preferable that the (C) component and the (A) component be mixed immediately before performing the cleaning.
In addition, when an alkali agent is used as an additional component, it is preferable that the (C) component and the alkali agent be mixed immediately before performing the cleaning. In this manner, it is possible to suppress hydrogen peroxide generated from the (C) component from being decomposed, and therefore it is possible to reliably prepare the cleaning composition.
Furthermore, in addition to the above-described preparation method, a preparation including the (C) component, and a preparation including the (A) component may be prepared in advance, and these preparations may be mixed when performing the cleaning. In this case, the (B1) component may be included in any one of the preparations.
Furthermore, in addition to the preparing method, a preparation including the (C) component, a preparation including the (B1) component, and a preparation including the (A) component may be prepared in advance, and these preparations may be mixed when performing the cleaning. It is preferable that a mixing sequence of the preparation including the (A) component and the preparation including the (C) component be apart from each other. In this manner, it is possible to suppress hydrogen peroxide generated from the (C) component from being decomposed, and therefore it is possible to reliably prepare the cleaning composition.

In regard to the cleaning composition in the first cleaning process, the cleaning composition (undiluted solution) may be used as it is, or may be used as a solution diluted with pure water (preferably, ultrapure water) or an additional solvent or the like.
When the cleaning composition is used as a diluted solution, it is preferable that the dilution rate thereof be 2 to 1000 times, and more preferably 2 to 100 times. When the dilution rate is equal to or less than the upper limit, it is possible to sufficiently remove both of the organic contaminant and the particle contaminant.

It is preferable that a pH of the cleaning composition (undiluted solution) exceed pH 7, more preferably be equal to or greater than pH 8, and even more preferably be equal to or larger than pH 9. When the pH of the cleaning composition preferably exceeds pH 7, and is more preferably equal to or greater than pH 8, it is possible to easily obtain a high cleaning level with respect to both of the organic contaminant and the particle contaminant adhered to the semiconductor substrate. Particularly, this is preferable, because the cleaning level with respect to the organic contaminant increases.
The pH of the cleaning composition (undiluted solution) represents a pH of the cleaning composition (undiluted solution) which is left still at 25°C for 10 minutes immediately after the cleaning composition is prepared.
The measurement of the pH is performed by immersing a pH electrode in a cleaning composition at 25°C using a pH meter (product name: HM-205, manufactured by DKK-TOA Corporation) and a pH electrode (product name: GST-5211C, manufactured by DKK-TOA Corporation) and by reading out an indicated value after the passing of 15 seconds.
In addition, in regard to the cleaning composition of the invention, the value of pH immediately after the preparation is not constant due to a mutual action of the (A) component, (B1) component, and the (C) component. Therefore, in the present invention, the pH of the cleaning composition (undiluted solution) after 10 minutes from the preparation, which shows a substantially constant pH, is measured.
The pH of the cleaning composition (undiluted solution) may be adjusted using an alkali agent or the like.

With Respect to Transition-Metal-Containing Water-Soluble Salt (A)
In regard to the (A) component, as the transition metal, elementary substances metal elements of group 3 to group 11 in an extended periodic table of elements may be exemplified. Among these, since a relatively high cleaning level is easily obtained with respect to both of the organic contaminant and the particle contaminant adhered to the semiconductor substrate, copper, iron, manganese, cobalt, nickel, or silver is preferable, and copper, iron, manganese, or cobalt is more preferable, and copper is most preferable.
As the water-soluble salt, sulfate, chloride, nitrate, bromate, or the like may be exemplified, sulfate, chloride, or nitrate is preferable because the solubility to a solvent such as water is particularly excellent, and sulfate is most preferable.
As the (A) component, specifically, sulfate such as copper sulfate, iron sulfate, manganese sulfate, cobalt sulfate, nickel sulfate, and silver sulfate; chloride such as copper chloride, iron chloride, manganese chloride, cobalt chloride, and nickel chloride; nitrate such as copper nitrate, iron nitrate, manganese nitrate, cobalt nitrate, nickel nitrate, and silver nitrate; bromate such as copper bromide, iron bromide, manganese bromide, cobalt bromide, and nickel bromide may be exemplified.
In addition, as the (A) component, hydrate of the compound may be used in addition to the compound.
The (A) compound may be used with one kind alone, or may be used with an appropriate combination of two or more kinds.
It is preferable that a blending amount of the (A) component be 0.003 to 0.4% in terms of anhydride from a viewpoint of a cleaning performance and inhibition against decomposition of hydrogen peroxide.

With Respect To Chelating Agent (B1)
As the (B1) component, for example, aminocarboxylate such as nitrilotriacetate, ethylenediamine tetraacetate, β-alanine diacetate, glutamine acid diacetate, asparagine acid diacetate, methylglycine diacetate, imino disuccinate, and diethylenetriamine pentaacetate; hydroxy amino carboxylate such as serine diacetate, hydroxy imino disuccinate, hydroxyethylethylenediamine triactetate, and a dihydroxyethyl glycine salt; hydroxy carboxylate such as hydroxy acetate, citrate, and gluconate; cyclo carboxylate such as a pyromellitic acid salt, benzo polycarboxylate, and cyclopentane tetracarboxylate; ether carboxylate such as a carboxymethyl tartronic acid salt, carboxymethyloxy succinate, oxydisuccinate, tartrate monosuccinate, and tartrate disuccinate; oxalate or an acid-type compound thereof may be exemplified.
In addition, as the (B1) component, a polymer chelating agent such as a maleic acid acrylic acid copolymer, carboxy methylated polyethylene imine, and a salt thereof; a phosphorous-based chelating agent such as tripolyphosphoric acid, hydroxy ethane diphosphonic acid, pyrophosphoric acid, and a salt thereof may be exemplified.
Among these, as the (B1) component, since a relatively high cleaning level is obtained with respect to all of the organic contaminant and the particle contaminant adhered to the semiconductor substrate, polycarboxylic acid-based compounds are preferable.

Among the polycarboxylic acid-based compounds, aminopolycarboxylate such as nitrilotriacetate, ethylenediamine tetraacetate, β-alanine diacetate, glutamine acid diacetate, asparagine acid diacetate, methylglycine diacetate, imino disuccinate, and diethylenetriamine pentaacetate; hydroxy amino polycarboxylate such as serine diacetate, hydroxy imino disuccinate, and hydroxyethylethylenediamine triactetate; hydroxy polycarboxylate such as citrate; cyclo polycarboxylate such as a pyromellitic acid salt, benzo polycarboxylate, and cyclopentane tetracarboxylate; ether polycarboxylate such as a carboxymethyl tartronic acid salt, carboxymethyloxy succinate, oxydisuccinate, tartrate monosuccinate, tartrate disuccinate; oxalate or an acid-type compound thereof; a polymer chelating agent such as a maleic acid acrylic acid copolymer or a salt thereof, and carboxy methylated polyethylene imine or a salt thereof are more preferable.
Among these, aminopolycarboxylate, hydroxy amino polycarboxylate, hydroxy polycarboxylate, or an acid-type compound thereof is even more preferable.

As a salt, an alkali metal salt such as a sodium salt and a potassium salt; and an alkanolamine salt such as a monoethanol amine salt, and a diethanol amine salt may be exemplified, and the sodium salt and the potassium salt are particularly preferable.

In the (B1) component, it is preferable that an amount of iron contained as an impurity be 0.2 ppm or less, more preferably 0.1 ppm or less, and even more preferably 0.02 ppm or less. When the amount of iron is 0.2 ppm or less, it is possible to prevent an extremely minute amount of iron from remaining on a substrate. In addition, the lower limit of the amount of iron is 0.0 ppm.

As a method of reducing the amount of iron in the (B1) component, a recrystallization method disclosed in Japanese Patent Application Laid-Open No, 10-17533, a chelating resin processing method disclosed in Japanese Patent Application Laid-Open No. 2001-228635, or the like may be exemplified. Particularly, the chelating resin processing method is preferable from a metal removing efficiency aspect. The kind of a chelating resin used in the chelating resin processing method is not limited, but a chelating resin in which a functional group such as an imino diacetic acid type, and a polyamine type is coupled to a styrene/divinyl benzene copolymer or cellulose fiber, or the like may be exemplified. Particularly, a chelating resin in which the imidodiacetic acid type functional group is coupled to styrene/divinyl benzene copolymer is preferable from the aspect of excellent metal-removing efficiency, and as an example of a commercially available product, DIAION CR-11 manufactured by Mitsubishi Chemical Corporation may be exemplified.

The (B1) component may be used as one kind alone, or may be used as an appropriate combination of two or more kinds. It is preferable that a blending amount of the (B1) component be 0.005 to 0.45% in terms of anhydride from a viewpoint of a cleaning performance and inhibition against the remaining of the (B1) component.

In the cleaning composition of the invention, it is preferable that a ratio of the (B1) component to the (A) component be 0.5 molar equivalents or more, and preferably 1 molar equivalent or more. When the ratio of the (B1) component is 0.5 molar equivalents or more with respect to the (A) component, it is possible to obtain a high cleaning level with respect to both of the organic contaminant and the particle contaminant adhered to a semiconductor substrate.
As the upper limit in the ratio of the (B1) component is high, the remaining of a transition metal, which is emitted from the (A) component, on the semiconductor substrate is suppressed, which is thus preferable. As the upper limit, substantially 10 molar equivalents or less is preferable, and 5 molar equivalents or less is more preferable. When a ratio of the (B1) component is equal to or less than the upper limit, the organic contaminant caused by the remaining of the (B1) component on the semiconductor substrate may be easily suppressed.
In addition, in this specification, a ratio (molar equivalent) of the (B1) component with respect to the (A) component may be expressed by (B1)/(A) (mole ratio).

In the cleaning composition of the invention, it is preferable that a total blending amount of the (A) component and the (B1) component be 0.01% by mass or more, and more preferably 0.01 to 0.5% by mass.
When the total blending amount of the (A) component and the (B1) component is 0.01% by mass or more, it is easy to obtain a relatively high cleaning level with respect to both of the organic contaminant and the particle contaminant attached to the semiconductor substrate. When the total blending amount is 0.5% by mass or less, it is possible to appropriately control a bubble release caused by a decomposition of hydrogen peroxide generated from a component (C) described later in the aqueous solution, and therefore it is possible to suppress a deactivation of a hydrogen peroxide from being accelerated.

### With Respect To Peroxide (C)

In the present specification and claims, it is assumed that hydrogen peroxide is included in the "peroxide".
The (C) component may be a component that is dissolved in hydrogen peroxide or water and generates hydrogen peroxide in an aqueous solution, and for example, hydrogen peroxide, percarbonic acid, perboric acid, an alkali metal salt thereof (a sodium salt, a potassium salt, or the like) or an ammonium salt thereof, or the like may be exemplified. Among these, since a relatively high cleaning level is easily obtained with respect to both of the organic contaminant and the particle contaminant adhered to the semiconductor substrate, hydrogen peroxide, sodium percarbonate, or sodium perborate is preferable, and hydrogen peroxide is more preferable.
The (C) compound may be used as one kind alone, or may be used as an appropriate combination of two or more kinds.
In the cleaning composition of the invention, a blending amount of the (C) component may be appropriately adjusted according to a degree of contamination of the semiconductor substrate, and 0.05 to 30% by mass is preferable, and 0.1 to 30% by mass is more preferable. When the blending amount of the (C) component is 0.05% by mass or more, it becomes easy to obtain a relatively high cleaning level with respect to both of the organic contaminant and the particle contaminant adhere to the semiconductor substrate. When the blending amount of the (C) component is 30% by mass or less, it is possible to appropriately control a bubble release caused by a decomposition of hydrogen peroxide. The more the blending amount of the (C) component increases, the more the cleaning property with respect to a persistent contaminant is improved.

### With Respect To Additional Component

The cleansing composition of the present invention may use an additional component other than the (A) component, the (B1) component, and the (C) component as necessary.
As the additional component, an alkali agent, a solvent, a surfactant, or the like may be exemplified.
As the alkali agent, an inorganic alkali agent such as ammonia, potassium hydroxide, and sodium hydroxide; and an organic alkali agent such as tetramethylammonium hydroxide, and tetraethylammonium hydroxide may be exemplified.
As the solvent, pure water, ultrapure water, ethanol, isopropyl alcohol, or the like may be exemplified.
The surfactant is not particularly limited, but anionic surfactant such as linear alkylbenzene sulfonate, alkyl sulfate, and alkylether sulfate; and nonionic surfactant such as an alkylene oxide additive of higher alcohol, and Pluoronic type surfactant, or the like may be exemplified.

### Acidic Solution

An acidic solution in the present invention includes a chelating agent (B2) (hereinafter, referred to as "(B2) component").
In regard to the acidic solution, the acidic solution (undiluted solution) may be used as it is, or may be used as a solution diluted with pure water (preferably, ultrapure water) or an additional solvent or the like.
The acidic solution in the present invention may include the (B2) component, and as an example, an acidic solution including the (B2) component, acid, and pure water (preferably, ultrapure water) may be exemplified.

### With Respect To Chelating Agent (B2)

As the (B2) component, the same as those exemplified in the description of the (B1) component may be exemplified.
Among these, as the (B2) component, since the complexation with a heavy metal or a transition metal is high even under an acidic condition, a polycarboxylic acid-based compound is preferable.
Among polycarboxylic acid-based compounds, as a more preferable one, aminopolycarboxylate such as nitrilotriacetate, ethylenediamine tetraacetate, methylglycine diacetate, and imino disuccinate; hydroxy amino polycarboxylate such as hydroxy imino disuccinate; hydroxy polycarboxylate such as citrate; ether polycarboxylate such as tartrate monosuccinate, and tartrate disuccinate; oxalate or an acid-type compound thereof, or the like may be exemplified.

As a salt, an alkali metal salt such as a sodium salt and a potassium salt; and an alkanolamine salt such as a monoethanol amine salt, and a diethanol amine salt may be exemplified, and the sodium salt and the potassium salt are particularly preferable.

In the (B2) component, it is preferable that an amount of iron contained as an impurity be 0.2 ppm or less, more preferably 0.1 ppm or less, and even more preferably 0.02 ppm or less. When the amount of iron is 0.2 ppm or less, it is possible to prevent an extremely minute amount of iron from remaining on a substrate. In addition, the lower limit of the amount of iron is 0.0 ppm.

Even though a method of reducing the amount of iron in the (B2) component is not inquired, a recrystallization method disclosed in Japanese Patent Application Laid-Open No. 10-17533, a chelating resin processing method disclosed in Japanese Patent Application Laid-Open No. 2001-228635, or the like may be exemplified. Particularly, the chelating resin processing method is preferable from a metal removing efficiency aspect. A kind of a chelating resin used in the chelating resin processing method is not limited, but a chelating resin in which a functional group such as an imino diacetic acid type, and a polyamine type is coupled to a styrene/divinyl benzene copolymer or cellulose fiber, or the like may be exemplified. Particularly, a chelating resin in which the iminodiacetic acid type functional group is coupled to styrene/divinyl benzene copolymer is preferable from an excellent metal-removing efficiency aspect, and as an example of a commercially available product, DIAION CR-11 manufactured by Mitsubishi Chemical Corporation may be exemplified.

The (B2) component may be used as one kind alone, or may be used as an appropriate combination of two or more kinds.
It is preferable that the lower limit of a blending amount of the (B2) component in the acidic solution of the present invention be 0.001% by mass in terms of anhydride, more preferably 0.01% by mass or more, and even more preferably 0.02% by mass or more. It is preferable that the upper limit be 5% by mass or less, more preferably 1% by mass or less, and even more preferably 0.1% by mass or less. When the blending amount is equal to or more than the lower limit, it becomes easy to obtain a relatively high cleaning level with respect to the metallic contaminant. When the blending amount is equal to or less than the upper limit, solubility of the (B2) component itself is improved, and therefore precipitation of the (B2) component in the acidic solution is suppressed.

### With Respect To Acid

The acid may be an organic acid or inorganic acid, and since there is no concern that an organic material remains on the semiconductor substrate, the inorganic acid is preferable. However, the "acid" described here indicates an acid other than one which corresponds to the acid in the (B2) component.
As the inorganic acid, for example, sulfuric acid, hydrochloric acid, nitric acid, hydrofluoric acid, or a mixture thereof may be used. Among these, since the hydrochloric acid and the hydrofluoric acid have volatility and a handling property is not good at the time of being used, the sulfuric acid, the nitric acid, or a mixture thereof is preferable.
The acid may be used with one kind alone, or may be used with an appropriate combination of two or more kinds.
In regard to the acidic solution of the present invention, it is preferable that a blending amount of the acid be 0.1% by mass or more as the lower limit, and more preferably 5% by mass or more. It is preferable that the upper limit be 90% by mass or less, and more preferably 50% by mass or less. When the blending amount of the acid is 0.1% by mass or more, it becomes easy to obtain a relatively high cleaning level with respect to the metallic contaminant. When the blending amount of the acid exceeds 90% by mass, the capacity for dissolving a metal decreases.

### With Respect To Additional Components

The acidic solution of the present invention may use an additional component other than acid and pure water (preferably, ultrapure water) as necessary, in addition to the (B2) component.
As the additional component, a solvent, a surfactant, or the like may be exemplified.
As the solvent, pure water, ultrapure water, ethanol, isopropyl alcohol, or the like may be exemplified.
The surfactant is not particularly limited, but anionic surfactant such as linear alkylbenzene sulfonate, alkyl sulfate, and alkylether sultate; and nonionic surfactant such as an alkylene oxide additive of higher alcohol, and Pluoronic type surfactant, or the like may be exemplified.

According to the above-described method of cleaning a semiconductor substrate of the present invention, for example, in the first cleaning process, an immersion cleaning of one batch is possible, such that the number of times of the rinsing process is small, and it is not necessary to perform the rinsing process plural times by using a large amount of ultrapure water in plural cleaning steps like the above-described "RCA cleaning". Therefore, environmental load becomes small.
In addition, according to the method of cleaning the semiconductor substrate of the present invention, in the first cleaning process, it is possible to remove the organic contaminant and the particle contaminant adhered to the semiconductor substrate with a very high cleaning level without using a highly concentrated strong acid or alkali, or a hydrofluoric acid that is a highly toxic aqueous solution. In addition, it is not necessary to use the highly concentrated strong acid, the highly concentrated alkali, and chemicals such as a hydrofluoric acid that has a high toxicity, such that the semiconductor substrate is barely damaged. In addition to this, workability is improved in the cleaning, such that equipment for realizing corrosion resistance or ventilation is not necessary. In addition, the amount of acid used is smaller on the whole compared to the "RCA cleaning" in the related art, such that the environmental load is reduced.
In this cleaning method, after the first cleaning process, a second cleaning process in which cleaning is performed using a specific acidic solution is provided, such that it is possible to remove the metallic contaminant with a very high cleaning level.
Therefore, according to the method of cleaning the semiconductor substrate of the present invention, it is possible to perform precision cleaning in which a cleaning level required in the semiconductor substrate is achieved. In addition, the method of cleaning the semiconductor substrate of the present invention is a simple method.

In the method of cleaning the semiconductor substrate of the invention, in the first cleaning process, the organic contaminant and the particle contaminant adhered to the semiconductor substrate are mainly removed at a high cleaning level with a specific cleaning composition. The reason why this effect is obtained is assumed as described below.
In the present invention, the cleaning composition includes the transition-metal-containing water-soluble salt (A), the chelating agent (B1), and the peroxide (C), in which the (B1) component is included in 0.5 molar equivalents or more with respect to the (A) component.
In the cleaning composition or during the cleaning, the (A) component and the (B1) component form a metallic complex (a complex compound and a complex salt). Particularly, when a ratio of the (B1) component with respect to the (A) component is set to 0.5 molar equivalents or more, it is possible to reliably form the metallic complex. It is assumed that the metallic complex has a high effect of activating hydrogen peroxide generated from the (C) component. Therefore, when the cleaning composition of the present invention is used, it is considered that the organic contaminant and the particle contaminant adhered to the semiconductor substrate may be removed at a high cleaning level.
In addition, from a fact that the cleaning of the particle contaminant adhered to the semiconductor substrate is realized, it is considered that the cleaning composition of the present invention is provided with an etching action.
In regard to the cleaning composition of the present invention, it is considered that for example, in a case where the cleaning composition is an aqueous solution type, the metallic complex is dissolved in the aqueous solution; and in a case where the cleaning composition is a granular type, the metallic complex forms a particle, or when this cleaning composition is dissolved in water, the metallic complex is formed.

On the semiconductor substrate that is an object to be cleaned, a metallic contaminant is present as a contaminant other than the organic contaminant and the particle contaminant. The metallic contaminant leads to a decrease in a semiconductor characteristic, such that it is necessary to remove the metallic contaminant adhered to the semiconductor substrate in the precision cleaning at a very high cleaning level.
The cleaning composition of the present invention actively uses the metal that is to be removed originally as a contaminant. Therefore, particularly, the cleaning effect with respect to the organic contaminant and the particle contaminant increases significantly compared to an effect in the related art.
In addition, it is difficult to obtain the above-described cleaning effect with an amount of metal included in the metallic contaminant that is present as a contaminant on the semiconductor substrate.

In the method of cleaning the semiconductor substrate of the present invention, the metallic contaminant (metal such as copper, iron, cobalt, manganese, and aluminum) adhered to the semiconductor substrate is mainly removed at a high cleaning level in the second cleaning process by using a specific acidic solution. The reason why this effect is obtained is assumed as described below.
The acidic solution in the present invention includes the chelating agent (B2).
In general, under an acidic condition, an ionization of the chelating agent does not easily occur. Therefore, the "effect of forming a chelating compound by being coordinated to a metallic ion" in the chelating agent decreases.
The amount of metal present in the metallic contaminant adhered to the semiconductor substrate is extremely small, and it is assumed that even in a chelating agent that is ionized a little under the acidic condition, the "effect of forming a chelating compound by being coordinated to a metallic ion" is sufficiently obtained with respect to such an extremely small amount of metal. Therefore, when the acidic solution including the chelating agent (B2) is used, it is considered that a cleaning level higher than that in the related art is obtained with respect to the metallic contamination. In addition, it is considered that it is not easy for the chelating agent (B2) with a small ionization ratio to be present on the semiconductor substrate after the cleaning.

For example, as described in Patent Document 2, in a silicon carbide semiconductor substrate, it is necessary to reduce an amount of metal remaining on the substrate after the cleaning to 1×10¹¹ atoms/cm² or less.
In the cleaning method of the present invention, even when the cleaning is performed using the cleaning composition that actively uses the metal as described above, the amount of metal remaining on the substrate after the cleaning may be reduced to 1×10¹¹ atoms/cm² or less, or 1×10¹⁰ atoms/cm² or less.
In addition, according to the cleaning method of the present invention, it is also possible to remove an aluminum contaminant that leads to deterioration in semiconductor characteristics.

The cleaning method of the present invention is a method that is very suitable for the cleaning of semiconductor substrates, and is particularly suitable for the cleaning of a silicon carbide semiconductor substrate among these.
In the silicon carbide semiconductor substrate, there are various kinds of lamination structures of a crystal, which is called Polytype, but according to the cleaning method of the present invention, it is possible to remove the contaminants adhered to the silicon carbide semiconductor substrate at a very high cleaning level regardless of the kind of Polytype.
In addition, to form a silicon carbide epitaxial film of a single Polytype on the silicon carbide semiconductor substrate, a substrate having a gradient called an off-angle that is inclined several angles from a crystalline axis may be used, but according to the cleaning method of the present invention, it is possible to remove contaminants adhered to the substrate having the gradient at a very high cleaning level regardless of the off-angle.
In addition, according to the cleaning method of the present invention, it is possible to remove, at a very high cleaning level, the contaminants adhered to any silicon carbide semiconductor substrate of the silicon carbide semiconductor substrate (a bulk substrate) before forming the above-described epitaxial film and the silicon carbide semiconductor substrate after forming the epitaxial film.
In addition, according to the cleaning method of the present invention, it is possible to remove the contaminants adhered to the silicon carbide semiconductor substrate at a very high cleaning level regardless the size of the silicon carbide semiconductor substrate.

In electronic device substrates, "silicon carbide" is one kind of compound semiconductor including carbon and silicon and has characteristics such as a high withstand-voltage, a high-temperature operation, and a low energy-loss, and there are great expectations for the silicon carbide as a technology able to realize low energy-consumption devices.
However, when the "RCA" cleaning in the related art, which is used for cleaning a silicon semiconductor substrate, is applied to the cleaning of the silicon carbide semiconductor substrate using silicon carbide having a physical property different from that of the silicon, the cleaning power with respect to the organic contaminant and the particle contaminant becomes insufficient. In addition, in the related art, for the purpose of cleaning through etching, a removal of metal, or the like, the hydrofluoric acid is used, but the hydrofluoric acid is a toxic substance, and furthermore, there is a concern that a carbon-fluorine coupling may occur between carbon atoms of the silicon carbide and fluorine atoms of the hydrofluoric acid due to the treatment of the hydrofluoric acid. The present inventors have found that this carbon-fluorine coupling leads to the deterioration in semiconductor characteristics.

In the cleaning method of the present invention, the use of the hydrofluoric acid is not necessary, and it is possible to clean the organic contaminant and the particle contaminant in addition to the metallic contaminant at a high cleaning level without deteriorating semiconductor characteristics. Therefore, the cleaning method of the present invention is a method particularly suitable for the silicon carbide semiconductor sub strate.

In regard to precision cleaning in an industrial field, the present invention provides a new precision cleaning method as an alternative to the method in the related art.

In addition, when a process of performing the cleaning method of the present invention is provided to a process of manufacturing a semiconductor substrate, it is possible to manufacture a semiconductor substrate in which the organic contaminant, the particle contaminant, and the metallic contaminant are removed at a high cleaning level, and which is excellent in semiconductor characteristics.

### Acidic Solution

The acidic solution of the present invention is used in the method of cleaning the semiconductor substrate of the present invention, and includes the chelating agent (B2).
The acidic solution of the present invention is the same as the acidic solution in the method of cleaning the semiconductor substrate of the present invention.

### Examples

The present invention will be described further in detail by using the following examples, but the present invention is not limited to these examples. In addition, if not particularly limited, "%" represents "% by mass", and is represented in terms of purity. In addition, in a case where a component is hydrate, "%" is represented by a blending amount in terms of anhydride.

### Preparation of Cleaning Composition

Cleaning compositions (1) to (4) shown in Table 1 were prepared as described below with compliance to a normal method, respectively.
A predetermined amount of ultrapure water was poured into a beaker (volume: 1000 mL) in which a magnetic stirrer is provided and which is formed of a fluorine resin, and a temperature of the ultrapure water was adjusted to 25°C, and then a predetermined amount of chelating agent (B1), a peroxide (C), an alkali agent, and a transition-metal-containing water-soluble salt (A) were sequentially blended while rotating the magnetic stirrer and thereby a cleaning compound was obtained.

### Preparation of Acidic Solution

An acid, a chelating agent (B2), and ultrapure water were mixed according to a composition shown in Tables 2 and 3, and thereby an acidic solution was prepared.

In addition, the blending amount unit in Tables 1 to 3 is % by mass and the blending amount of each component represents an amount in terms of purity.
"Balance" in the Tables represents a blending amount of the ultrapure water in the cleaning composition or the acidic solution, which is blended in such a manner that the total amount of each component included in the cleaning composition or the acidic solution reaches 100% by mass.
In Table 1, "(A)+(B1) (% by mass)" represents a total blending amount (% by mass) of the (A) component and the (B1) component in the cleaning composition. In addition, in Table 1, "(B1)/(A) (mole ratio)" represents a ratio (molar equivalent) of the (B1) component to the (A) component.
In the Tables, a blank column represents that the corresponding component is not blended.
Hereinafter, components shown in Tables will be described.

### Transition-Metal-Containing Water-Soluble Salt (A)

A1: Copper sulfate pentahydrate (Kanto Chemical Co., Inc., special grade), and a molecular weight thereof is 249.7 (a molecular weight in terms of an anhydride is 159.6).
A2: Manganese sulfate pentahydrate (Kanto Chemical Co., Inc., special grade), and a molecular weight thereof is 241.1 (a molecular weight in terms of an anhydride is 151.0).
A3: Calcium fluoride dihydrate (Kanto Chemical Co., Inc., special grade), and a molecular weight thereof is 147.0 (a molecular weight in terms of an anhydride is 111.0), a comparative component of the (A) component.

### Chelating Agent (B1)

B11: Iminodisuccinic acid tetrasodium salt (IDS-4Na, BaypureCX-100 manufactured by LANXESS, Lot. CHASMH1102), a molecular weight thereof is 337.1, and 34% aqueous solution.
B12: Citric acid tri sodium dihydrate (Kanto Chemical Co., Inc., first grade), and a molecular weight thereof is 294.1 (a molecular weight in terms of an anhydride is 258.1).
B 13: Sodium acetate (Wako Pure Chemical Industries, Ltd., special grade), and a molecular weight thereof is 82.0; a comparative component of the (B1) component.

### Peroxide (C)

Hydrogen peroxide: Kanto Chemical Co., Inc., EL.

### Alkali agent

Sodium hydroxide (Kanto Chemical Co., Inc., UGR).

### Acid

Sulfuric acid (Kanto Chemical Co., Inc., EL).
Nitric Acid (Kanto Chemical Co., Inc., EL).
Hydrochloric Acid (Kanto Chemical Co., Inc., Ultrapur-100).

### Chelating agent (B2)

B21: Iminodisuccinic acid tetrasodium salt (IDS-4Na, BaypureCX-100 manufactured by LANXESS, Lot. CHASMH1102), a molecular weight thereof is 337.1, and 34% aqueous solution.
B22: Hydroxy imino disuccinic acid tetrasodium salt (HIDS-4Na, manufactured by, Nippon Shokubai Co., Ltd), a molecular weight thereof is 353.1, and 50% aqueous solution.
B23: Methylglycine diacetic acid trisodium salt (MGDA-3 Na, trade name: Trilon M, manufactured by BASF), a molecular weight thereof is 271.1, and 40% aqueous solution.
B24: Ethylenediamine tetraacetic acid (Kanto Chemical Co., Inc., special grade), and a molecular weight thereof is 292.2.
B25: Nitrilotriacetic acid trisodium salt (trade name: Trilon A, manufactured by BASF), a molecular weight thereof is 257.1, and powder of 92% purity.
B26: Citric acid (Kanto Chemical Co., Inc., special grade), and a molecular weight thereof is 192.1.
B27: Oxalic acid dihydrate (Kanto Chemical Co., Inc., special grade), and a molecular weight thereof is 126.1 (a molecular weight in terms of anhydride is 90.0).
B28: DL-tartaric acid (Kanto Chemical Co., Inc., special grade), and a molecular weight thereof is 150.1.

### Measurement of pH of Cleaning Composition

A pH of the cleaning composition shown in Table 1 was measured as described below.
10 mL of a cleaning composition, which was obtained by adding a predetermined amount of the (B1), (C), alkali agent, and (A) component and mixing for 10 seconds in the preparation of the cleaning composition, is taken immediately using a sample bottle, and was left still at 25°C for 10 minutes with not covered with a cover. Then, the pH of the cleaning composition (undiluted solution) was measured.
The measurement of the pH is performed by immersing a pH electrode in a cleaning composition at 25°C using a pH meter (product name: HM-205, manufactured by DKK-TOA Corporation) and a pH electrode (product name: GST-5211C, manufactured by DKK-TOA Corporation) and by reading out an indicated value after the passing of 15 seconds.

**[Table 1]**

| | Cleaning composition | | | |
|---|---|---|---|---|
| | (1) | (2) | (3) | (4) |
| (A) Water-soluble salt | A1 | A1 | A2 | A3 |
| (B1) Chelating agent | B11 | B11 | B12 | B13 |
| (A) [% by mass] | 0.032 | 0.049 | 0.011 | 0.058 |
| (B1) [% by mass] | 0.068 | 0.051 | 0.019 | 0.042 |
| (A+B1) [% by mass] | 0.1 | 0.1 | 0.03 | 0.1 |
| (C) Peroxide | 25 | 25 | 25 | 25 |
| Alkali agent (NaOH) [% by mass] | 2 | 2 | 2 | 2 |
| Ultrapure water | Balance | Balance | Balance | Balance |
| Sum [% by mass] | 100 | 100 | 100 | 100 |
| Amount of preparation [g] | 1000 | 1000 | 1000 | 1000 |
| (B1)/(A) [mole ratio] | 1 | 0.5 | 1 | 1 |
| pH of cleaning composition | 9.6 | 9.2 | 8.9 | 13.8 |

### Evaluation of Cleaning Level on Various Contaminants in Semiconductor Substrate

An evaluation of a cleaning level on various contaminants (an organic contaminant, a particle contaminant, and a metallic contaminant) in a semiconductor substrate was performed with respect to a silicon carbide semiconductor substrate for evaluation, which was obtained after a cleaning test described below immediately using the cleaning composition obtained by adding a predetermined amount of the (B1), (C), alkali agent, and (A) component and mixing for 10 seconds in the preparation of the cleaning composition.

### Cleaning Test

### Production of Object to be Cleaned

A contaminated silicon carbide substrate was produced as an object to be cleaned.
A silicon carbide substrate (manufactured by Nippon Steel Corporation; 2 inches, trade name: Polytype 4H, Si surface finish polishing is completed) was attached and secured to a polishing mount using a wax (manufactured by NIKKA SEIKO CO.LTD, trade name: ALCOWAX).
Using a polishing device (manufactured by Buehler; product name: AutoMet2000, EcoMet3000), a colloidal silica polishing slurry (manufactured by Buehler, trade name: MasterMet) was dripped onto a polishing buff (manufactured by Buehler, trade name: MasterTex), and the secured silicon carbide substrate was polished for two minutes while a load of 5 pounds was applied thereto.
The silicon carbide substrate was detached from the polishing mount, was cleaned with 100 mL of flowing ultrapure water, and was dried to produce a contaminated silicon carbide substrate.

### Examples 1 to 16 and Comparative Examples 2 and 3

First, the contaminated silicon carbide substrate was cleaned using cleaning compositions (1) to (4) respectively shown in Tables 2 and 3, respectively (first cleaning process).
Subsequently, the contaminated silicon carbide substrate, which was cleaned through the first cleaning process, was cleaned using acidic solutions of a composition shown in Tables 2 and 3, respectively (second cleaning process).
An evaluation was performed of a cleaning level related to the organic contaminant, particle contaminant, and metallic contaminant with respect to the contaminated silicon carbide substrate after the second cleaning process.

### First Cleaning Process

The contaminated silicon carbide substrate mounted on a dipper made of a fluorine resin was put in a 1000 mL beaker made of a fluorine resin, and 700 mL of a cleaning composition (undiluted solution) was poured into the beaker. Subsequently, a temperature was adjusted to 80 °C and an immersion cleaning was performed for 30 minutes.

### Second Cleaning Process

The contaminated silicon carbide substrate, which was cleaned through the first cleaning process, was taken out and was rinsed with flowing ultrapure water for 30 seconds.
Subsequently, the contaminated silicon carbide substrate was put in a different 1000 mL beaker made of a fluorine resin and 700 mL of acidic solution (undiluted solution) was poured into the beaker. Subsequently, a temperature was adjusted to 80 °C and an immersion cleaning was performed for 10 minutes.

After the cleaning through the second cleaning process, the contaminated silicon carbide substrate was taken out, and was rinsed for one minute while flowing ultrapure water was overflowed using a different 1000 mL beaker made of a fluorine resin.
Subsequently, the contaminated silicon carbide substrate was taken out, and the contaminated silicon carbide substrate was immersed in isopropyl alcohol (Kanto Chemical Co., Inc., EL) heated to 50°C using a different 1000 mL beaker made of a fluorine resin. Then, the contaminated silicon carbide substrate was slowly lifted at a speed of 1 cm/minute to be taken out from the beaker made of a fluorine resin and then dried. Accordingly, a silicon carbide semiconductor substrate for evaluation was obtained.

### Comparative Example 1

In a comparative example 1, the first cleaning process was performed, and the rinsing was performed for one minute while flowing ultrapure water was overflowed. Subsequently, the contaminated silicon carbide substrate was immersed in isopropyl alcohol (Kanto Chemical Co., Inc., EL) heated to 50°C using a different 1000 mL beaker made of a fluorine resin. Then, the contaminated silicon carbide substrate was slowly lifted at a speed of 1 cm/minute to be taken out from the beaker made of a fluorine resin and then dried. Accordingly, a silicon carbide semiconductor substrate for evaluation was obtained.

### Evaluation of Cleaning Level With Respect to Organic Contaminant

2 µL of ultrapure water was dripped onto a surface of the silicon carbide semiconductor substrate for evaluation, and a contact angle at 25°C was measured by using a contact angle meter (product name: Contact angle meter CA-X type, manufactured by Kyowa Interface Science Co., Ltd.). However, the "contact angle" described here indicates a static contact angle, that is, an angle made between a surface of the silicon carbide semiconductor substrate for evaluation that is horizontally disposed and a surface of a water droplet on the silicon carbide semiconductor substrate for evaluation.
The cleaning level with respect to the organic contaminant was evaluated based on the following evaluation criteria using the resultant measured contact angle as an index. The results thereof are shown in Tables 2 and 3.
In addition, the contact angle in the non-cleaned contaminated silicon carbide substrate before the cleaning with the cleaning composition was 70°.

### Evaluation Criteria

A: 45° or less
B: Exceeding 45° and 50° or less
C: Exceeding 50° and 55° or less
D: Exceeding 55° and 60° or less
E: Exceeding 60°

### Evaluation of Cleaning Level With Respect to Particle Contaminant

A surface of the silicon carbide semiconductor substrate for evaluation was observed by using a scanning probe microscope (AFM) (product name: NanoScope III, manufactured by Veeco Instruments Inc.), and the resultant observed image was visually observed to measure the number of particles having 5 nm or more in diameter, which was detected in a 30 µm × 30 µm region in the surface of the silicon carbide semiconductor substrate for evaluation.
The cleaning level with respect to the particle contaminant was evaluated based on the following evaluation criteria using the resultant measured number of particles as an index. The results thereof are shown in Tables 2 and 3.
In addition, the number of particles in the non-cleaned contaminated silicon carbide substrate before the cleaning with the cleaning composition was 500.

### Evaluation Criteria

A: 0 to 10
B: 11 to 50
C: 51 to 100
D: 101 to 200
E: 201 or more

### Evaluation of Cleaning Level With Respect To Metallic Contaminant

Amounts of copper, iron, cobalt, and manganese atoms remaining on the surface of the silicon carbide semiconductor substrate for evaluation were determined by using total reflection X-ray fluorescence spectrometers TREX630 manufactured by Technos Corp., the sum of the numbers of these atoms was obtained as the "amount of heavy metal", and the evaluation of a cleaning level with respect to the metallic contaminant was performed based on the following evaluation criteria. The evaluation results are shown in Tables 2 and 3.
In addition, the determined value (sum of the number of atoms) of the copper, iron, cobalt, and manganese atoms in the contaminated silicon carbide substrate after the first cleaning process and before the cleaning process with the acidic solution of each example (non-cleaning) was substantially 9.2×10¹⁵ atoms/cm² (exceeding 1×10¹² atoms/cm²)_{.}
The determination of the amount of the metal atoms was performed by making a calibration curve using a Si standard sample to which metal atoms of a known amount were attached. It is preferable that an evaluation result be 1×10¹¹ atoms/cm² or less, more preferably 5×10¹⁰ atoms/cm² or less, and even more preferably 1×10¹⁰ atoms/cm² or less.

### Evaluation Criteria

A: 1×10¹⁰ atoms/cm² or less
B: Exceeding 1×10¹⁰ atoms/cm² and 5×10¹⁰ atoms/cm² or less
C: Exceeding 5×10¹⁰ atoms/cm² and 1×10¹¹ atoms/cm² or less
D: Exceeding 1×10¹¹ atoms/cm² and 1×10¹² atoms/cm² or less
E: Exceeding 1×10¹² atoms/cm²

**[Table 2]**

| | | | Examples | | | | | | | | | |
|---|---|---|---|---|---|---|---|---|---|---|---|---|
| | | | 1 | 2 | 3 | 4 | 5 | 6 | 7 | 8 | 9 | 10 |
| Cleaning composition in first cleaning process | | | (1) | (1) | (1) | (1) | (1) | (1) | (1) | (1) | (1) | (1) |
| | Acid | Sulfuric acid | 20 | 20 | 20 | 20 | 20 | 20 | 20 | 20 | 20 | 20 |
| | | Nitric acid | 20 | 20 | 20 | 20 | 20 | 20 | 20 | 20 | 20 | 20 |
| | (B2) Chelating agent | B21 | 0.1 | 0.02 | 0.001 | | | | | | | |
| | | B22 | | | | 0.02 | | | | | | |
| Cleaning | | B23 | | | | | 0.02 | | | | | |
| composition | | B24 | | | | | | 0.02 | | | | |
| in second | | B25 | | | | | | | 0.02 | | | |
| cleaning | | B26 | | | | | | | | 0.02 | | |
| process | | B27 | | | | | | | | | 0.02 | |
| | | B28 | | | | | | | | | | 0.02 |
| | Ultrapure Water | | Balance | Balance | Balance | Balance | Balance | Balance | Balance | Balance | Balance | Balance |
| | Sum [% by mass] | | 100 | 100 | 100 | 100 | 100 | 100 | 100 | 100 | 100 | 100 |
| | Amount of preparation [g] | | 1000 | 1000 | 1000 | 1000 | 1000 | 1000 | 1000 | 1000 | 1000 | 1000 |
| | Cleaning level with respect to organic contaminant | | A | A | A | A | A | A | A | A | A | A |
| Performance | Cleaning level with respect to particle contaminant | | A | A | A | A | A | A | A | A | A | A |
| | Cleaning level with respect to metallic contaminant | | A | B | C | B | B | B | B | C | C | C |

**[Table 3]**

| | | | Examples | | | | | | Comparative Examples | | |
|---|---|---|---|---|---|---|---|---|---|---|---|
| | | | 11 | 12 | 13 | 14 | 15 | 16 | 1 | 2 | 3 |
| Cleaning composition in first cleaning process | | | (1) | (1) | (1) | (1) | (2) | (3) | (1) | (1) | (4) |
| | Acid | Sulfuric acid | 40 | | 10 | | 20 | 20 | | 20 | 20 |
| | | Nitric acid | | 40 | 10 | | 20 | 20 | | 20 | 20 |
| Cleaning composition second | | Hydrochloric acid | | | | 20 | | | | | |
| in cleaning | (B2) | B21 | 0.02 | 0.02 | 0.02 | 0.02 | 0.02 | 0.02 | | | 0.02 |
| | Ultrapure water | | Balance | Balance | Balance | Balance | Balance | Balance | | Balance | Balance |
| process | Sum [% by mass] | | 100 | 100 | 100 | 100 | 100 | 100 | | 100 | 100 |
| | Amount of preparation [g] | | 1000 | 1000 | 1000 | 1000 | 1000 | 1000 | | 1000 | 1000 |
| | Cleaning level with respect to organic contaminant | | A | A | A | A | A | B | A | A | E |
| Performance | Cleaning level with respect to particle contaminant | | A | A | A | A | C | C | A | A | E |
| | Cleaning level with respect to metallic contaminant | | C | C | C | C | B | C | E | D | A |

From the results shown in Tables 2 and 3, it can be confirmed that when with respect to the silicon carbide semiconductor substrate, the cleaning (first cleaning process) with the cleaning composition of the present invention was performed and then the cleaning (second cleaning process) with the acidic solution was performed, it is possible to remove any of the organic contaminant, particle contaminant, and metallic contaminant adhered to the silicon carbide semiconductor substrate at a high cleaning level.
In addition, from the comparison between examples 1 to 10 and comparative example 2, it can be seen that when the acidic solution containing the chelating agent (B2) is used in the second cleaning process, it is possible to remove the metallic contaminant at an even higher cleaning level (in the order of 10¹⁰ (atoms/cm²)).

As described above, according to the cleaning method of examples 1 to 16 related to the present invention, it can be confirmed that it is possible to remove all of the organic contaminant, the particle contaminant, and the metallic contaminant adhered to the semiconductor substrate at a high cleaning level.
In addition, according to the cleaning method of examples 1 to 16, the environmental load is reduced compared to the RCA cleaning in the related art.

### Reduction of Amount of Iron from Components of Chelating Agents (B1) and (B2)

200 mL of a chelating resin DIAION CR-11 (manufactured by Mitsubishi Chemical Corporation, styrene/divinyl benzene copolymer to which an iminodiacetic acid type functional group is coupled) was filled into a column, which was 3 cm in diameter and 30 cm in length and made of a fluorine resin (through a tapping method), 75 mL of BaypureCX-100 (manufactured by LANXESS, Lot. CHASMH1102) 34% aqueous solution was made to flow at a flowing rate of 25 mL/h, and a recovered solution was condensed in an evaporator and was diluted with ultrapure water to adjust a concentration thereof to 34%. Accordingly, a purified chelating agent was obtained. The purified chelating agent was obtained as a purified chelating agent (B14) obtained after performing the above-described process one time, and a purified chelating agent (B 15) obtained after performing the above-described process two times. 2 g of the purified chelating sample was put in a crucible, and 10 mL of a nitric acid and several droplets of a concentrated sulfuric acid were added into the crucible, and the crucible was heated to 300°C on a hot plate in a clean room fume hood. When the resultant mixture was vigorously boiled and the nitric acid was volatilized, the nitric acid was added each time this happened, and when the mixture was vigorously boiled and reddish brown smoke was generated, the heating was terminated and a dilution was performed with 5 g of ultrapure water. Then, an amount of iron was measured by Perkin-Elmer Optima 5300 dual view that is an ICP emission spectrophotometer. The amount of iron contained for each chelating agent before and after the process is shown in Table 4.

**[Table 4]**

| | Not-processed | After solution is made to flow one time (B14) | After solution is made to flow two times (B15) |
|---|---|---|---|
| Amount of iron (ppm) | 0.5 | 0.18 | 0.02 |

### Cleaning Test

As a substrate that is an object to be cleaned, a substrate that is an object to be cleaned, which was manufactured by the same method as that in the substrate used in the evaluation of Tables 2 and 3, was used. As a cleaning composition in the first cleaning process, a cleaning composition shown in Table 5, which was prepared by the same method as that in the compositions shown in Table 1, was used. As a cleaning composition in the second cleaning process, a cleaning composition shown in Table 6, which was adjusted by the same method as those in the compositions shown in Tables 2 and 3, was used. In the cleaning method, the method of evaluating the cleaning level with respect to the organic contaminant, and the method of evaluating the cleaning level with respect to the particle contaminant, the same methods as that in the test shown in Tables 2 and 3 were used.

**[Table 5]**

| | Cleaning composition | |
|---|---|---|
| | (5) | (6) |
| (A) Water-soluble salt | A1 | A1 |
| (B1) Chelating agent | B14 | B15 |
| (A) [% by mass] | 0.032 | 0.032 |
| (B1) [% by mass] | 0.068 | 0.068 |
| (A)+(B1) [% by mass] | 0.1 | 0.1 |
| (C) Peroxide | 25 | 25 |
| Alkali agent (NaOH) [% by mass] | 2 | 2 |
| Ultrapure water | Balance | Balance |
| Sum [% by mass] | 100 | 100 |
| Amount of preparation [g] | 1000 | 1000 |
| (B1)/(A) [mole ratio] | 1 | 1 |
| pH of cleaning composition | 9.6 | 9.6 |

### Evaluation of Cleaning Level With Respect To Iron Contaminant

An amount of iron atoms remaining on the surface of the silicon carbide semiconductor substrate for evaluation was determined by using total reflection X-ray fluorescence spectrometers TREX630 manufactured by Technos Corp., the number of the iron atoms was obtained, and the evaluation of a cleaning level with respect to the iron contaminant was performed based on the following evaluation criteria.

### Evaluation Criteria

A: 0.6×10¹⁰ atoms/cm² or less (equal to or less than a detection limit)
B: Exceeding 0.6×10¹⁰ atoms/cm² and 1.0×10¹⁰ atoms/cm² or less
C: Exceeding 1.0×10¹⁰ atoms/cm² and 5.0×10¹⁰ atoms/cm² or less
D: Exceeding 5.0×10¹⁰ atoms/cm²
Evaluation results are shown in Table 6.

**[Table 6]**

| | | | Examples | | | | Comparative Example s | |
|---|---|---|---|---|---|---|---|---|
| | | | 17 | 18 | 19 | 20 | 4 | 5 |
| Cleaning composition in first cleaning process | Composition of cleaning agent | | (5) | (5) | (6) | (6) | (5) | (6) |
| | (B1) Component | | B14 | B14 | B15 | B15 | B14 | B15 |
| | Acid | Sulfuric acid | 20 | 20 | 20 | 20 | | |
| | | Nitric acid | 20 | 20 | 20 | 20 | | |
| | B14 | | 0.1 | | 0.1 | | | |
| Cleaning composition in | B15 | | | 0.1 | | 0.1 | | |
| second cleaning process | Ultrapure water | | Balance | Balance | Balance | Balance | | |
| | Sum [% by mass] | | 100 | 100 | 100 | 100 | | |
| | Amount of preparation [g] | | 1000 | 1000 | 1000 | 1000 | | |
| | Cleaning level with respect to organic contaminant | | A | A | A | A | A | A |
| Performance | Cleaning level with respect to particle contaminant | | A | A | A | A | A | A |
| | Cleaning level with respect to iron contaminant | | B | B | B | A | D | D |

From the results shown in Table 6, it can be confirmed that when with respect to the silicon carbide semiconductor substrate, the cleaning (first cleaning process) with the cleaning composition of the present invention was performed and then the cleaning (second cleaning process) with the acidic solution was performed, it was possible to remove the iron contaminant adhered to the silicon carbide semiconductor substrate at a high cleaning level.

### Industrial Applicability

According to the method of cleaning a semiconductor substrate, it is possible to remove, particularly, an organic contaminant, a particle contaminant, or a metal contaminant adhered to a semiconductor substrate at a high cleaning level, and to realize the reduction in environmental load caused by the cleaning. Particularly, in a case where the amount of iron included in the chelating agents (B1) and (B2) is reduced, it is possible to realize the removal of the iron at an even higher cleaning level. In addition, when the acidic solution of the invention is used, it is possible to remove the metallic contamination at a high cleaning level that is required for, particularly, a semiconductor sub strate.

## Claims

1. A method of cleaning a semiconductor substrate, comprising:
a first cleaning process of cleaning the semiconductor substrate with a cleaning composition including a transition-metal-containing water-soluble salt (A), a chelating agent (B1), and a peroxide (C), a ratio of the chelating agent (B1) to the transition-metal-containing water-soluble salt (A) being 0.5 molar equivalents or more; and
a second cleaning process of cleaning the semiconductor substrate, which is cleaned in the first cleaning process, with an acidic solution containing a chelating agent (B2).

2. The method according to claim 1,
wherein the chelating agent (B1) is a polycarboxylic acid-based compound.

3. The method according to claim 1 or 2,
wherein the chelating agent (B2) is a polycarboxylic acid-based compound.

4. The method according to any one of claims 1 to 3,
wherein an amount of iron contained in the chelating agents (B1) and (B2) is 0.2 ppm or less.

5. The method according to any one of claims 1 to 4,
wherein the semiconductor substrate is a silicon carbide semiconductor sub strate.

6. An acidic solution which is used in a method of cleaning semiconductor substrate according to any one of claims 1 to 5, and which includes a chelating agent (B2).
